# FASCICULE DE BREVET EUROPEEN

(11) **EP 1 428 247 B1**
(45) Date de publication et mention de la délivrance du brevet: **16.02.2011**
(21) Numéro de dépôt: 02774890.4
(22) Date de dépôt: 30.08.2002
(51) Int. Cl.: H01L 21/00

(54) **PROCEDE DE FABRICATION D'UN TRANSISTOR A EFFET DE CHAMP A GRILLES AUTO-ALIGNEES HORIZONTALES**
HERSTELLUNGSVERFAHREN FÜR FELDEFFEKTTRANSISTOR MIT SELBSTJUSTIERTEN HORIZONTALEN GATES
PRODUCTION METHOD FOR FIELD-EFFECT TRANSISTOR WITH HORIZONTAL SELF-ALIGNED GATES

(30) Priorité: 03.09.2001 FR 0111366
(43) Date de publication de la demande: 16.06.2004
(73) Titulaire: Commissariat à l'Énergie Atomique et aux Énergies Alternatives, 75015 Paris (FR)
(72) Inventeur: DELEONIBUS, Simon, F-38640 Claix (FR)
(74) Mandataire: Poulin, Gérard
(86) Numéro de dépôt international: PCT/FR2002/002972
(87) Numéro de publication internationale: WO 2003/021633

(56) Documents cités:
- US-A- 5 349 228
- US-A- 5 583 362
- US-A- 5 773 331
- US-A- 6 166 412

## Description

### Domaine technique

La présente invention concerne un transistor à effet de champ, à grilles auto-alignées horizontales. Elle concerne également un procédé pour la fabrication d'un tel transistor.

On entend par transistor à grilles horizontales un transistor dont les grilles s'étendent pour l'essentiel selon un plan parallèle à une face principale d'un substrat sur lequel le transistor est réalisé. L'invention concerne en particulier un transistor à grille double c'est-à-dire un transistor comprenant deux grilles disposées sur deux faces opposées d'une région de canal.

Des transistors du type mentionné ci-dessus trouvent principalement des applications dans la fabrication de circuits numériques, pour la réalisation de commutateurs logiques ou de circuits analogiques destinés, par exemple, à des dispositifs radiofréquence. Des applications peuvent être aussi trouvées dans d'autres domaines de l'électronique.

### Etat de là technique antérieure.

Les documents (1) à (4), dont les références sont précisées à la fin de la description concernent des transistors à grille isolée double. Il s'agit en particulier de tels transistors fabriqués sur des substrats de type silicium sur isolant, SOI (Silicon On Insulator).

Pour la fabrication des transistors à double grille on utilise un substrat dans lequel une première grille a été préalablement formée, et comprenant une couche de canal au-dessus de la première grille. La deuxième grille est formée sur le substrat par le dépôt d'une couche de matériau de grille et par la gravure de cette couche pour la mettre en forme. La deuxième grille peut être utilisée comme masque de dopage pour un dopage auto-aligné des régions de source et de drain.

Une des difficultés principales apparaissant dans la fabrication de transistors à double grille est liée à l'alignement des grilles l'une sur l'autre, et à leur alignement sur la région de canal. L'alignement des grilles est d'autant plus délicat que la miniaturisation des transistors est grande. La qualité de l'alignement tient essentiellement à la précision de la mise en place d'un masque de gravure pour la mise en forme de la deuxième grille.

Un défaut d'alignement, même s'il ne compromet pas le fonctionnement du transistor, a pour effet de rendre le transistor dissymétrique. La dissymétrie conduit à une augmentation de capacités parasites grille/source, ou grille/drain, encore appelées capacités de Miller. L'augmentation des capacités de Miller conduit à une altération du comportement dynamique des transistors et donc une réduction de leur vitesse de commutation ou de leur fréquence de coupure.

Un autre effet néfaste de la dissymétrie des transistors, particulièrement sensible dans des applications numériques, est la définition approximative des niveaux logiques haut et bas (0 et 1). Les documents de brevet US-A-5 349 228, US-A-5 771 331 et US-A-6 166 412, montrent des procédés de fabrication de transistors à effet de champ à doubles grilles auto-alignées.

### Exposé de l'invention

La présente invention a pour but de proposer un procédé pour fabriquer un transistor à double grille qui ne présente pas les limitations ci-dessus.

Un but est en particulier de proposer un procédé pour fabriquer un tel transistor qui soit parfaitement symétrique pour une définition régulière de niveaux logiques haut et bas.

Un autre but est encore de proposer un procédé pour fabriquer un transistor présentant des capacités parasites réduites et un comportement dynamique amélioré.

L'invention a enfin pour but de proposer différents procédés pour la réalisation d'un tel transistor.

Pour atteindre les buts indiqués ci-dessus, l'invention a plus précisément pour objet un procédé pour fabriquer un transistor à effet de champ selon les revendications comprenant sur un substrat :
- une région active formant un canal,
- une première grille isolée associée à une première face de la région active,
- des régions de source et de drain formées dans une partie de la région active, de part et d'autre du canal, et auto-alignées sur la première grille,
- une deuxième grille isolée associée à une deuxième face de la région active, opposée à la première face de la région active.

Conformément à l'invention, la deuxième grille, qui est la plus proche du substrat de support, est auto alignée sur la première grille et forme avec la première grille une structure de mesa sur le substrat de support du transistor.

Au sens de la présente invention, on considère que deux parties d'un composant sont auto-alignées lorsque l'une des parties est utilisée comme un outil dans la fabrication de l'autre partie, de sorte que la partie fabriquée en second soit automatiquement alignée, ou tout au moins centrée sur la première. L'auto-alignement n'est pas tributaire de la précision d'un quelconque outil d'alignement extérieur.

L'auto-alignement consiste essentiellement à utiliser une partie d'un composant comme masque pour une opération de gravure, d'oxydation, ou de dopage d'une autre partie. Il autorise un alignement parfait des parties impliquées. L'autre partie est alors auto-alignée sur la partie du composant servant de masque.

Grâce au caractère auto-aligné des grilles, le transistor se trouve être parfaitement symétrique et répond aux objectifs visés par l'invention.

Les deux grilles, de même qu'éventuellement une partie de canal, présentent une structure de mesa symétrique. En d'autres termes, ils forment une éminence symétrique sur le substrat, caractéristique d'un traitement auto-aligné.

L'invention concerne un procédé de réalisation d'un tel transistor, et plus généralement d'un transistor à grilles auto-alignées selon les revendications.
- la formation d'un empilement de couches comprenant à partir d'un substrat de support : une première couche de grille, une couche d'isolant de grille, une couche active, une deuxième couche d'isolant de grille, et une deuxième couche de grille,
- la définition d'une grille, dite grille supérieure, dans la deuxième couche de grille,
- la formation dans la couche active de régions de source et de drain auto-alignées sur la grille supérieure, et
- la formation d'une grille, dite inférieure, disposée entre le substrat de support et la couche active, la grille inférieure étant formée de façon auto-alignée sur la grille supérieure.

On considère que la formation de la grille inférieure est auto-alignée sur la grille supérieure lorsqu'elle est auto-alignée sur cette grille nue ou sur cette grille garnie d'autres éléments auto-alignés tels que des espaceurs latéraux.

Bien que le procédé fasse explicitement référence à un transistor, il peut être mis en oeuvre pour la fabrication concomitante d'une pluralité de transistors. Par ailleurs les couches de matériau mentionnées ci-dessus peuvent être des couches simples ou constituées d'une ou de plusieurs sous-couches.

La grille inférieure peut être réalisée dans la première couche de grille. Elle peut aussi, comme évoqué plus loin être formée dans une autre couche qui remplace la première couche de grille.

Lors de sa formation, la grille inférieure est délimitée dans la première couche de grille par gravure sélective auto-alignée sur la grille supérieure. La grille supérieure peut aussi être utilisée comme masque d'implantation pour doper, par implantation, la première couche de grille. On grave sélectivement la partie dopée de la première couche de grille pour former la grille inférieure.

Comme évoqué ci-dessus la formation de la grille inférieure peut comporter le remplacement de la première couche de grille par une ou plusieurs nouvelles couches de grille, puis la délimitation auto-alignée de la nouvelle couche de grille.

La nouvelle couche de grille est délimitée par un dopage auto-aligné et une gravure sélective.

Selon un aspect particulier de la mise en oeuvre du procédé, on peut former des première et deuxième grilles s'étendant dans une région s'étendant au delà de la région active. Dans ce cas, on pratique avantageusement dans la région s'étendant au-delà de la région active un puits métallisé traversant l'empilement des couches pour relier électriquement la grille supérieure à la grille inférieure.

L'interconnexion des grilles permet de leur appliquer le même potentiel pour la commande du transistor, en évitant ainsi de multiplier les bornes d'accès de grille.

Dans le procédé ci-dessus on peut mettre à profit la grille supérieure non seulement pour délimiter la grille inférieure mais aussi pour délimiter le canal dans la couche active. Par exemple, le procédé peut comporter en outre la gravure auto-alignée de la couche active, en utilisant la grille supérieure comme masque de gravure.

Avant cette gravure des espaceurs latéraux peuvent être formés sur la grille supérieure.

Pour délimiter la grille inférieure, on peut mettre à profit la grille supérieure et éventuellement la couche active préalablement gravée. Des deuxièmes espaceurs peuvent être prévus à cet effet sur les flancs de la structure formée par la première grille et la couche active gravée. L'utilisation d'espaceurs permet d'obtenir une grille inférieure s'étendant au-delà de la grille supérieure tout en restant parfaitement alignée, ou plus précisément centrée, sur celle-ci.

D'autres caractéristiques et avantages de l'invention ressortiront de la description qui va suivre, en référence aux figures des dessins annexés. Cette description est donnée à titre purement illustratif et non limitatif.

### Brève description des figures.

Les figures 1 et 2A sont des coupes schématiques d'empilements de couches illustrant la fabrication d'un substrat pour la formation d'un transistor conforme à l'invention.
La figure 2B est une coupe de l'empilement de la figure 2A selon un plan de coupe perpendiculaire au plan de coupe de la figure 2A.
Les figures 3A et 3B sont des coupes schématiques du substrat de la figure 2A illustrant la mise en forme d'une grille supérieure du transistor.
La figure 4 est une coupe schématique du dispositif de la figure 3 illustrant la mise en forme d'une couche active du transistor.
La figure 5 est une coupe schématique du dispositif de la figure 4 illustrant une étape préparatoire de la mise en forme d'une grille inférieure du transistor.
Les figures 6 à 8 sont des coupes schématiques du dispositif de la figure 5 illustrant la mise en forme de la grille inférieure du transistor selon l'invention.
Les figures 9 à 11 sont des coupes schématiques du dispositif de la figure 8 illustrant une isolation de la grille inférieure du transistor.
Les figures 12 et 13 sont des coupes schématiques du dispositif de la figure 11 et illustrent des étapes de préparation pour la formation de prolongements latéraux de source et de drain.
La figure 14 est une coupe schématique du dispositif de la figure 13 illustrant la formation de prolongements latéraux de source et de drain.
La figure 15 est une coupe schématique du dispositif de la figure 14 illustrant le conditionnement du transistor et la formation de prises de contact de source et de drain.
Les figures 16 et 17 sont des coupes schématiques du dispositif de la figure 3 et illustrent des étapes de fabrication d'un transistor selon une variante du procédé précédemment décrit.
Les figures 18 à 22 sont des coupes schématiques du dispositif de la figure 5 et illustrent des étapes de fabrication d'un transistor selon une autre variante du procédé précédemment décrit.
La figure 23 est une coupe schématique du dispositif de la figure 21 et illustre une étape de fabrication d'un transistor selon encore une autre variante du procédé précédemment décrit.
Les figures 24 et 25 sont des coupes schématiques du dispositif de la figure 22 et illustrent des étapes de fabrication d'un transistor selon une variante de l'invention.
Les figures 26 à 29 sont des coupes schématiques du dispositif de la figure 4 et illustrent différentes étapes de la fabrication du transistor dans une région d'extrémité de grille.
Les figures 30 et 31 sont des coupes schématiques du dispositif de la figure 29 et illustrent la fabrication d'une prise de contact de grille.
Les figures 32A et 32B sont des coupes schématiques du dispositif de la figure 30 selon un plan de coupe parallèle au plan des différentes couches du transistor, et passant dans la couche active
La figure 33 est une coupe schématique du dispositif de la figure 4, formé sur un substrat conforme à la figure 2A, selon un plan de coupe passant hors d'une région active.

### Description détaillée de modes de mise en oeuvre de l'invention.

Dans la description qui suit des parties identiques, similaires ou équivalentes des différentes figures sont repérées par les mêmes signes de référence pour faciliter le report entre les figures. Par ailleurs, et dans un souci de clarté des figures, tous les éléments ne sont pas représentés selon une échelle uniforme.

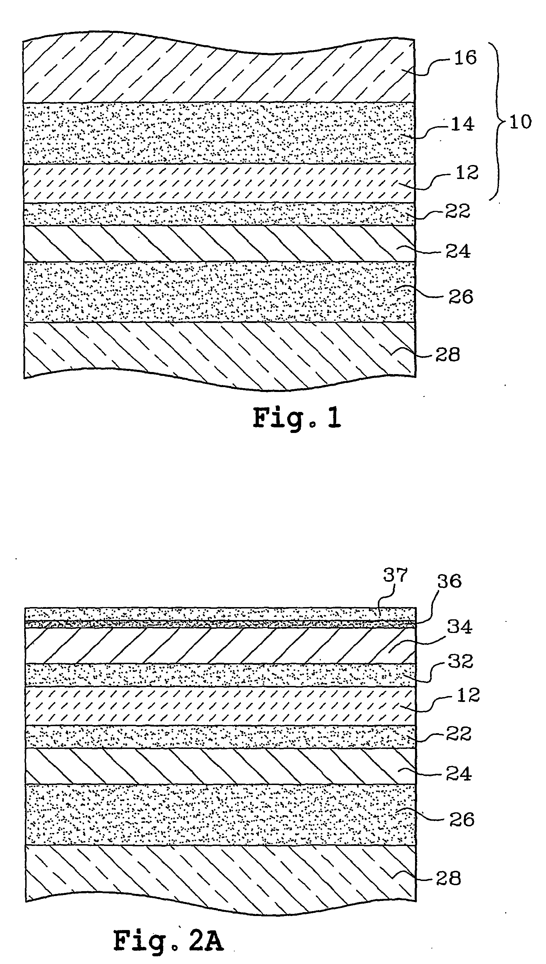

La figure 1 montre une étape de préparation d'un substrat pour la fabrication d'un ou de plusieurs transistors conformes à l'invention.

La référence 10 sur la figure 1 désigne un substrat de type SOI avec une couche superficielle mince de silicium monocristallin 12 éventuellement dopée, une couche enterrée d'oxyde de silicium 14 et une couche de silicium massif 16. Sur le substrat sont successivement formées une première couche d'isolant de grille 22, une première couche de grille 24, et une couche d'isolant de base 26.

La couche d'isolant de grille 22 est par exemple une couche d'oxyde de silicium. La première couche de grille 24 peut être une couche conductrice en un matériau métallique ou, dans l'exemple décrit, en un matériau semi-conducteur tel que le silicium polycristallin. La couche d'isolant de base 26 est de préférence en oxyde de silicium ou en oxyde de métal. Elle peut être déposée ou formée par oxydation d'une partie de la couche de grille 24.

La couche d'isolant de base 26 est ensuite collée sur un bloc de silicium massif 28 pour former l'empilement de la figure 1. Il s'agit, par exemple, d'un collage moléculaire direct.

La figure 2A montre l'élimination de la couche enterrée d'oxyde 14 et de la couche de silicium massif 16 du substrat SOI 10, pour n'en laisser subsister que la couche mince 12. Celle-ci est encore désignée par "couche active" dans la suite du texte. La couche active de silicium 12 est ensuite recouverte par des dépôts successifs d'une deuxième couche d'isolant de grille 32, d'une deuxième couche de grille 34, et d'une couche de recouvrement de grille 36 et d'une couche 37 de tampon de surgravure.

Tout comme la première couche de grille 24, la deuxième couche de grille peut être métallique, par exemple en W, Ti, TiN, Hf, Zr, etc., ou semi-conductrice, par exemple, en silicium polycristallin, ou en une combinaison de plusieurs couches de ces matériaux. Eventuellement, d'autres matériaux peuvent encore être retenus pour une formation préalable d'une grille supérieure factice, qui est ultérieurement remplacée par une grille définitive.

La couche de recouvrement de grille 36 est une couche isolante, par exemple, en nitrure de silicium. La couche de tampon 37 est, par exemple, en oxyde de silicium (SiO₂). Son rôle est décrit dans la suite du texte.

Il convient de préciser qu'avant la formation de la deuxième couche d'isolant de grille 32 et de la deuxième couche 34 de grille, la couche active 12 peut être gravée selon un motif défini par un masque de gravure non représenté, pour la délimiter de façon préalable. Cet aspect sera encore évoqué dans la suite de la description.

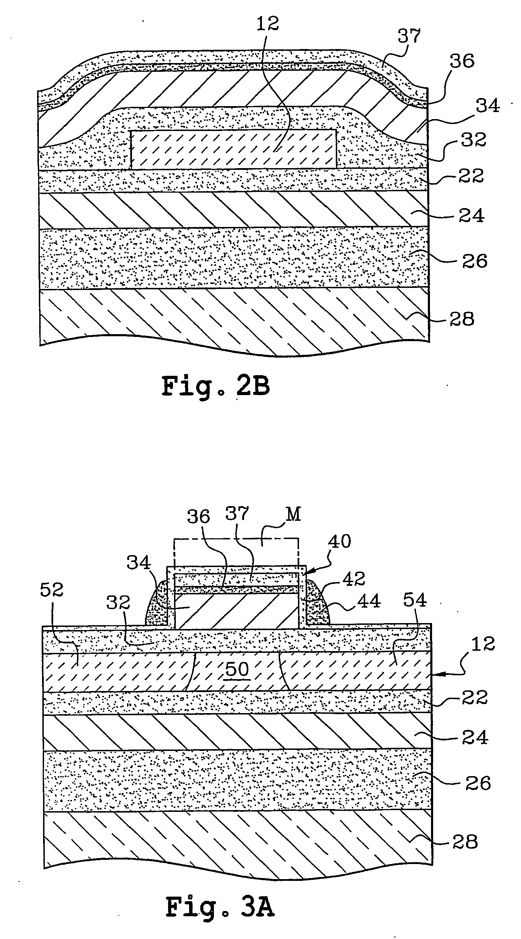

La figure 2B, qui est une coupe de l'empilement de couches selon un plan de coupe perpendiculaire au plan de la figure 2A, permet de voir le prolongement latéral d'une région active définie dans la couche active 12 délimitée de la façon indiquée ci-dessus. Au-delà de cette région, la deuxième couche d'isolant de grille 32 n'est plus séparée de la première couche d'isolant de grille 22 et repose directement sur celle-ci. La région active est également repérée par la référence 12 pour des raisons de commodité.

La figure 3A montre une première opération visant à mettre en forme la grille supérieure. La couche de grille 34 et la couche de recouvrement de grille 36 sont soumises à une gravure anisotrope sélective, avec arrêt sur la deuxième couche d'isolant de grille 32. Un masque de gravure M représenté en trait discontinu permet de protéger, lors de cette gravure, la partie des couches destinées à former la grille supérieure 40. Le masque M est éliminé après la gravure des couches.

Après la première gravure, une première couche de piédestal 42 est formée sur la grille 40. Il s'agit, par exemple d'une couche d'oxyde de silicium. La première couche de piédestal 42 est garnie de premiers espaceurs latéraux 44 en nitrure de silicium. Ils sont formés par dépôt conforme d'une couche de nitrure de silicium puis par gravure anisotrope de cette couche pour en enlever les parties qui recouvrent des surfaces parallèles au plan des couches. Lors de cette gravure anisotrope, la couche tampon 37 protège la couche de recouvrement.

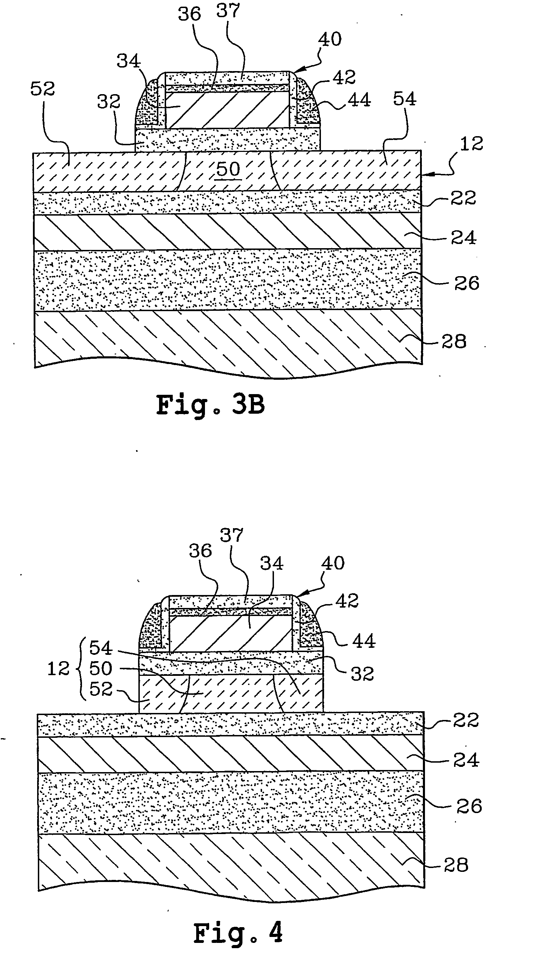

La grille 40, flanquée de la couche de piédestal 42 et des premiers espaceurs 44 est utilisée comme masque de gravure lors d'une gravure subséquente de la deuxième couche d'isolant de grille 32. Il s'agit, comme le montre la figure 3B, d'une gravure auto-alignée et sélective de la couche d'isolant de grille avec arrêt sur la couche active 12. Lors de cette gravure, la partie de la couche de piédestal 42 recouvrant la couche tampon 37 est éliminée. La couche tampon peut également être entamée lors de cette gravure.

Avant ou après cette gravure, on procède à un dopage de la couche active au moyen d'impuretés dopantes de type opposé à celui de la couche 12 pour y former des régions de source 52 et de drain 54. Le dopage est réalisé, par exemple, par une implantation d'ions d'impuretés dopantes, auto-alignée sur la grille 40. Lors de cette opération la grille 40 peut être flanquée ou non des espaceurs 42.

Un traitement thermique d'activation des impuretés dopantes provoque une légère diffusion sous la grille 40. La partie de la couche active 12 située sous le milieu de la grille 40, c'est-à-dire la partie préservée du dopage lors de la formation de la source et du drain, constitue une région de canal 50. Lorsque la couche active 12 est préalablement dopée, elle l'est avec des impuretés de type opposé à celui des impuretés utilisées pour le dopage des source et drain.

Après la formation des régions de source et de drain, la couche active 12 est également gravée sélectivement avec arrêt sur la première couche d'isolant de grille 22. Il s'agit encore, comme le montre la figure 4, d'une gravure auto-alignée qui utilise la grille 40, flanquée du premier piédestal 42 et de l'espaceur 44, comme masque de gravure.

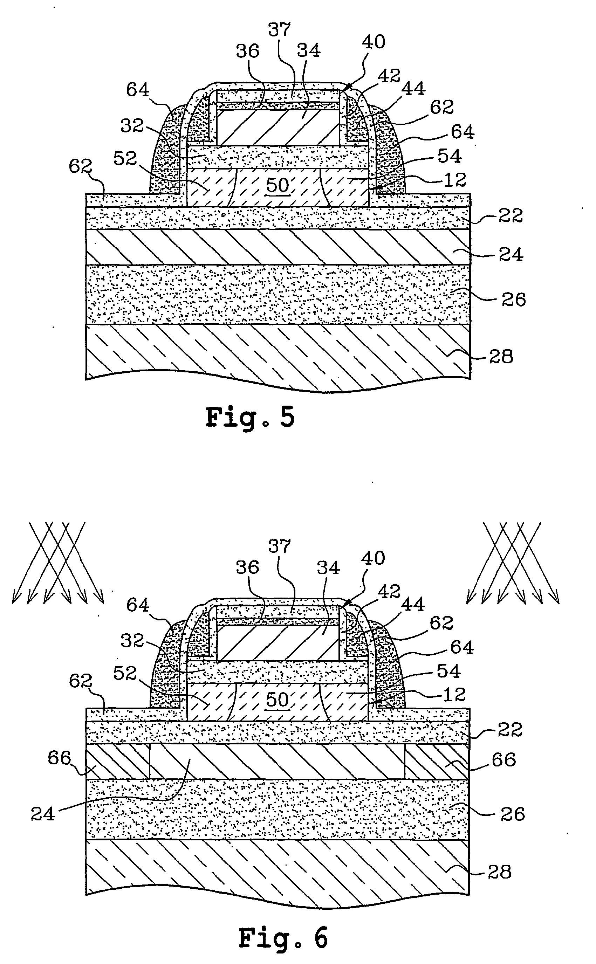

La figure 5, montre la formation d'une deuxième couche de piédestal 62 et d'un deuxième espaceur 64 sur le flanc de l'ensemble comprenant la grille supérieure 40 déjà équipée d'un espaceur, de la deuxième couche d'isolant de grille 32, et de la couche active 12 telle que délimitée par la gravure.

Dans l'exemple décrit, la deuxième couche de piédestal 62, et le deuxième espaceur 64 sont respectivement en oxyde de silicium et en nitrure de silicium.

Une étape suivante, illustrée par la figure 6, comprend une implantation d'impuretés dopantes dans la première couche de grille 24. Il s'agit, par exemple, d'impuretés de germanium, de bore ou de carbone. L'énergie d'implantation est choisie suffisante pour traverser la deuxième couche de piédestal 62, si celle-ci n'est pas préalablement éliminée, et pour traverser la première couche d'isolant de grille 22. Cette implantation est une implantation auto-alignée sur la grille. Elle utilise en effet, comme masque d'implantation, la grille, flanquée des premier et deuxième espaceurs, ainsi que des couches de piédestal. Les régions dopées de la première couche de grille de part et d'autre de la grille sont indiquées avec la référence 66.

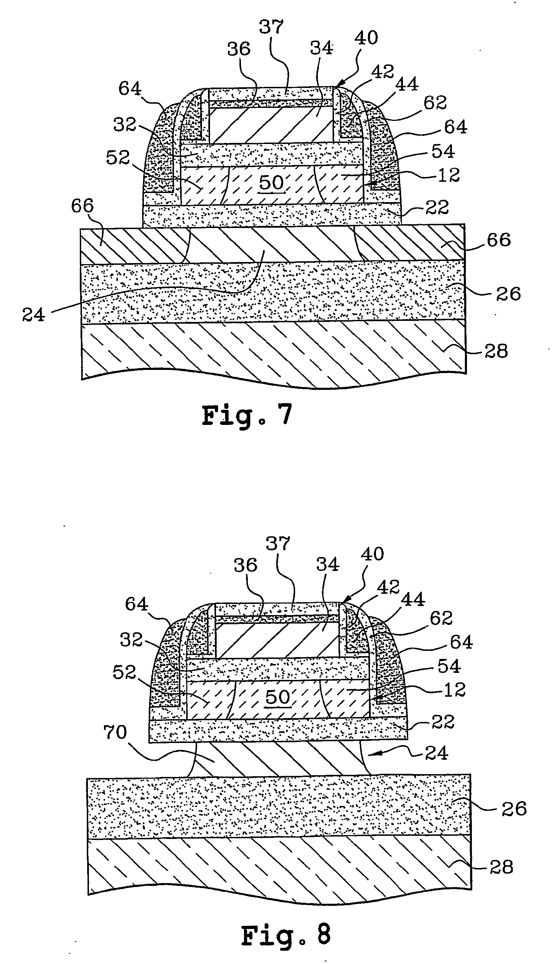

Un traitement thermique d'activation permet de faire diffuser légèrement les espèces dopantes implantées et ajuster, comme le montre la figure 7, le prolongement latéral des régions dopées 66 sous le masque d'implantation.

La figure 7 montre également la gravure sélective de la deuxième couche de piédestal 62 et de la première couche d'isolant de grille 22. Cette gravure est encore auto-alignée. Elle utilise la grille, flanquée des espaceurs 44, 64 comme masque de gravure et met à nu des parties des régions dopées 66, non protégées par le masque de gravure.

La gravure a pour effet d'éliminer la partie de la deuxième couche de piédestal 62 recouvrant la couche de tampon 37, et éventuellement d'entamer la couche de tampon. La couche de tampon est prévue suffisamment épaisse pour ne pas être entièrement retirée.

La figure 8 montre une gravure sélective des régions dopées pour ne préserver de la couche de grille 24 qu'une partie 70 qui constitue la grille inférieure. La gravure est sélective par rapport à l'isolant de grille 22, par rapport à la couche d'isolant de base 26, par rapport aux espaceurs, et, bien sûr, par rapport au matériau de la couche de grille non dopé. Comme toutes les opérations précédentes sont auto-alignées, et en particulier les opérations de dopage et de gravure de la couche d'isolant de grille, la grille inférieure se trouve également auto-alignée, et donc centrée, sur la grille supérieure 40.

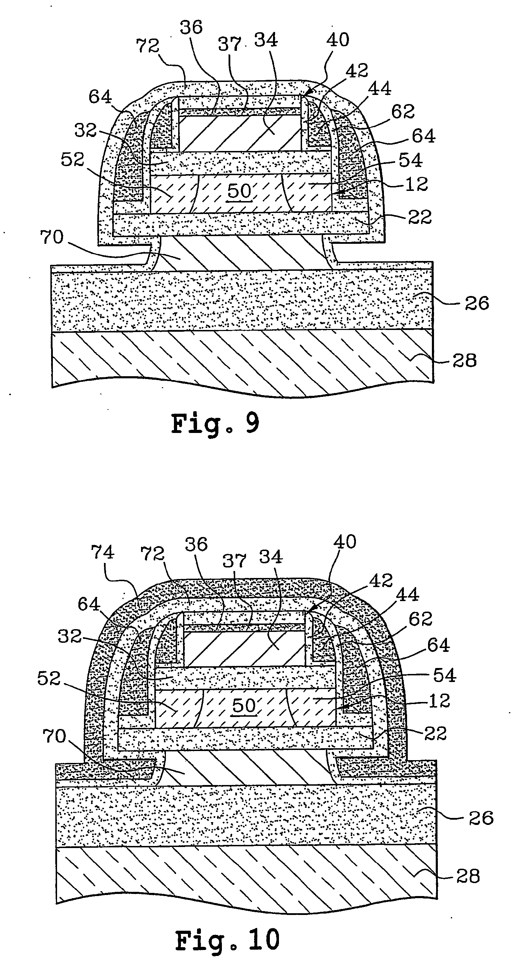

La figure 9 montre la formation d'une troisième couche de piédestal 72. Il s'agit d'une couche d'oxyde de silicium déposée. La troisième couche de piédestal 72 tapisse la couche d'isolant de base 26, les flancs de la grille inférieure 70, la première couche d'isolant de grille 22, le deuxième espaceur 64, et la couche de tampon 37 restant au sommet de la grille supérieure 40.

La formation de la troisième couche de piédestal est suivie par le dépôt conforme d'une couche de nitrure de silicium 74. Celle-ci est destinée à former un troisième espaceur. La figure 10 montre que la couche de nitrure de silicium recouvre entièrement la troisième couche de piédestal et vient combler une cavité située sous la deuxième couche d'isolant de grille 22 et bordant la grille inférieure 70. Cette cavité est celle libérée lors de la gravure des régions dopées qui ont servi à ajuster le prolongement latéral de la grille inférieure. Dans le plan de la figure 10, elle s'étend de part et d'autre de la grille inférieure.

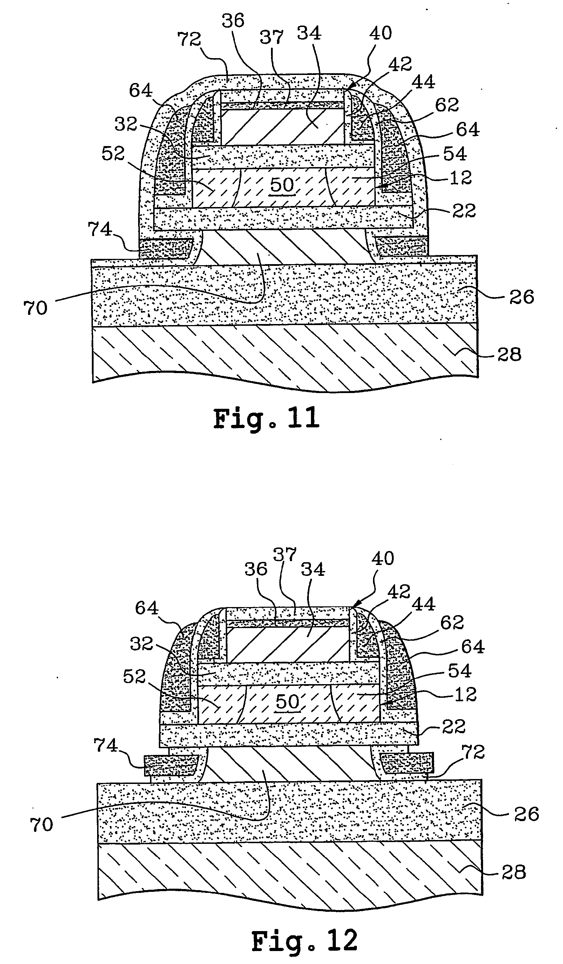

La figure 11 montre le résultat d'une gravure anisotrope sélective de la couche superficielle de nitrure de silicium 74 avec arrêt sur la troisième couche de piédestal 72 sous-jacente. Comme la gravure est anisotrope, la partie de la couche de nitrure de silicium présente dans la cavité bordant la grille inférieure, est préservée. Elle constitue un troisième espaceur enfoui qui par commodité est également repéré avec la référence 74.

On décrit à présent un certain nombre d'opérations destinées à prendre des contacts sur différentes parties du transistor et notamment sur les régions de source et de drain.

Un certain nombre de gravures sélectives permettent d'éliminer successivement les couches isolantes qui recouvrent latéralement les régions de source et de drain 52, 54. Une première étape, illustrée par la figure 12 montre le retrait de la troisième couche de piédestal. Le retrait de cette couche a lieu par une gravure sélective de l'oxyde de silicium de la troisième couche de piédestal par rapport au nitrure de silicium des deuxième et troisième espaceurs 64, 74. Au-dessus de la grille, l'oxyde de silicium de la couche tampon 37 n'est pas entièrement retiré : il protège la couche de recouvrement 36. La couche de recouvrement 36 peut aussi être préservée en l'absence de la couche tampon 37 en lui conférant une épaisseur initiale suffisamment importante pour ne pas disparaître entièrement lors du retrait des espaceurs.

On observe aussi, sur la figure 12, un reliquat de la troisième couche de piédestal 72 protégée en partie par l'espaceur enfoui 74.

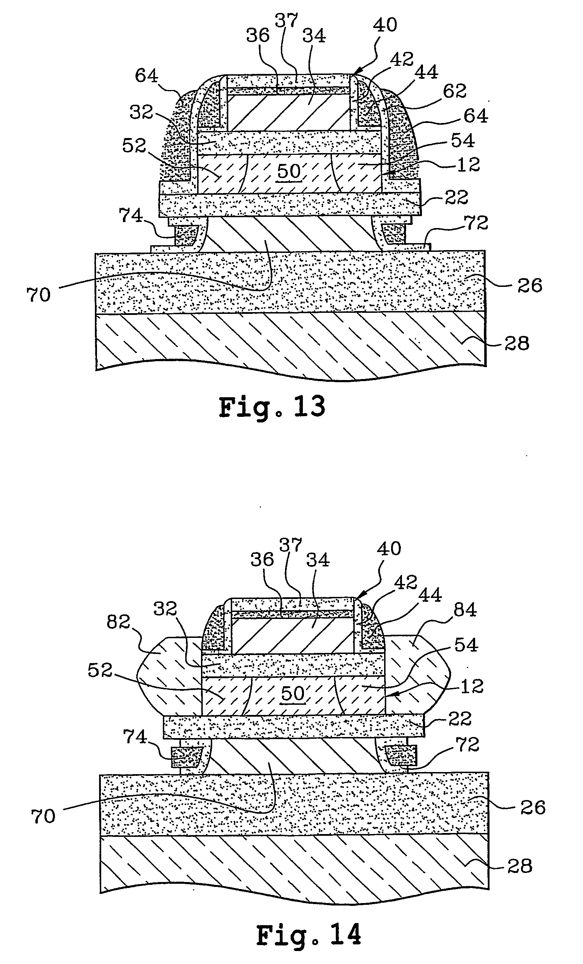

Une deuxième gravure sélective, illustrée par la figure 13, est destinée maintenant à retirer le nitrure de silicium des deuxième et troisième espaceurs. Cette gravure est sélective et se fait avec arrêt sur l'oxyde de silicium de la deuxième couche de piédestal 62 désormais mise à nu. On peut observer que, dans l'exemple illustré, le troisième espaceur enfoui 74 n'est pas entièrement éliminé en raison de son épaisseur.

Une troisième gravure est destinée à éliminer sélectivement l'oxyde de silicium de la deuxième couche de piédestal 62. Cette gravure permet de mettre à nu des flancs des régions de source et de drain 52, 54, de la deuxième couche d'isolant de grille 22 et le premier espaceur 44.

La troisième gravure est suivie d'une épitaxie sélective de silicium sur la couche de silicium monocristallin 12 et plus précisément les flancs des régions de source et de drain 52, 54. L'épitaxie est illustrée par la figure 14. La sélectivité de croissance est garantie par les première et deuxième couches d'isolant de grille, et par l'espaceur enfoui 74, ou tout au moins la partie de la troisième couche de piédestal 72 protégée par l'espaceur enfoui. La sélectivité de croissance est encore garantie par le premier espaceur 44 et par la première couche de piédestal ou la couche de nitrure de silicium 36 au sommet de la grille. L'épitaxie permet de former des régions de prolongement latéral de source et de drain, 82, 84. Ces régions présentent des facettes imposées initialement par les bords de la couche monocristalline des source et drain. Les facettes sont conservées pendant tout le processus de croissance.

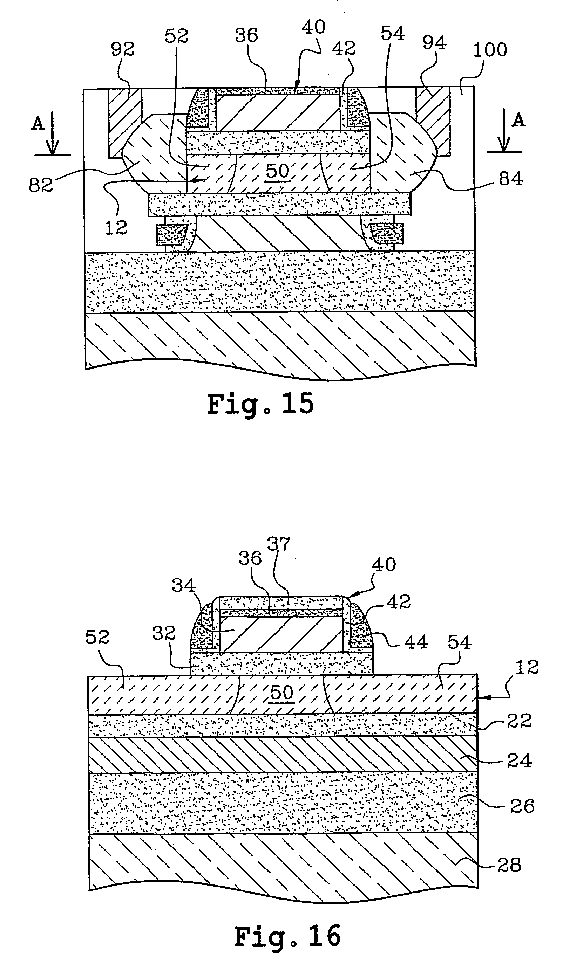

La figure 15 illustre un conditionnement du transistor de la figure 14. La structure mesa de la figure 14 est recouverte d'une couche épaisse 100 de matériau isolant, tel que de la silice. La couche 100 subit un planage, par exemple par polissage mécano-chimique, avec arrêt sur la première couche de piédestal au sommet de la grille ou sur la couche de recouvrement de grille 36 en nitrure de silicium. Des puits sont gravés dans la couche isolante 100 à l'aplomb des prolongements latéraux de source et de drain 82, 84. Dans la mesure où les prolongements latéraux sont suffisamment larges, l'alignement de la gravure des puits est facilité. Les puits sont comblés d'un matériau conducteur électrique, par exemple d'un métal, qui vient prendre contact sur les prolongements latéraux de source et de drain au fond de chaque puits. Le métal, après mise en forme, constitue des prises de contact 92, 94 pour l'interconnexion du transistor avec d'autres composants. La réalisation de prises de contact sur les grilles est décrite ultérieurement.

On peut ajouter que, si les matériaux de grille mentionnés précédemment n'étaient pas des matériaux définitifs, et que la grille 40 est une grille factice, son remplacement peut également avoir lieu après le dépôt et le planage de la couche isolante.

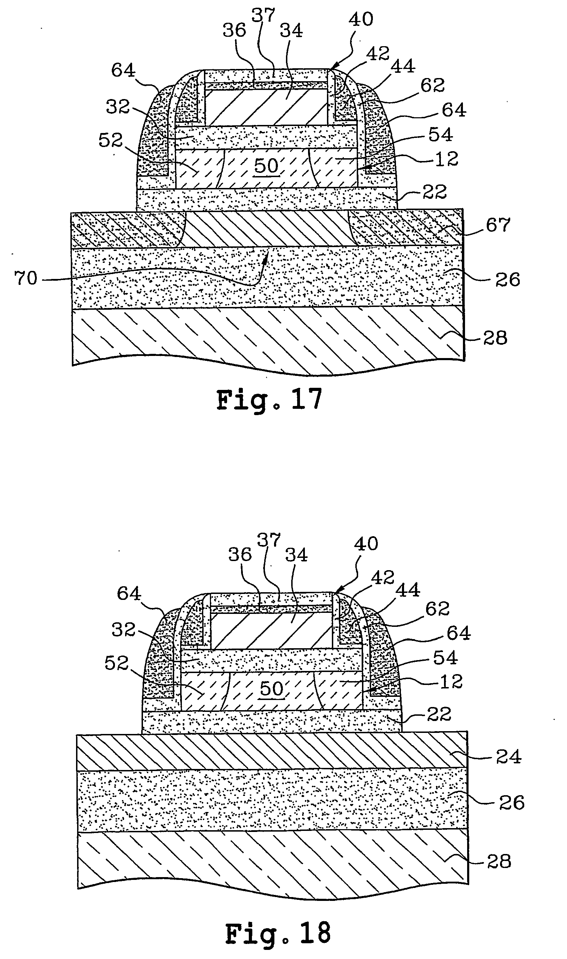

Les figures 16 et 17, décrites ci-après illustrent la mise en oeuvre d'une variante du procédé. La figure 16 montre un dispositif identique à celui de la figure 3B. A ce stade du procédé, la grille 40 avec la première couche de piédestal 42 et le premier espaceur 44 sont formés. Des régions de source et de drain 52, 54 sont formées dans la couche active 12 qui n'est pas encore gravée. La deuxième couche d'isolant de grille 32, en revanche, a déjà subi une gravure auto-alignée sur la grille flanquée de la couche de piédestal 42 et du premier espaceur 44. Il convient de noter qu'à la différence de la figure 3B, la première couche de grille 24 de l'empilement visible à la figure 16 est une couche de métal. Il s'agit, par exemple, d'une couche de W, TiN, Hf, Zr ou un alliage de ces derniers.

De façon comparable au procédé illustré par la figure 4, la figure 17 montre la formation de la deuxième couche de piédestal 62, et du deuxième espaceur 64. La deuxième couche de piédestal et le deuxième espaceur sont formés après la gravure de la couche active. Cette gravure est auto-alignée sur la grille flanquée du premier espaceur, de sorte que les espaceurs recouvrent de façon égale les flancs des régions de source et de drain. Les premier et deuxième espaceurs, de même que les couches de piédestal, associés à la grille supérieure 40, constituent un masque de gravure pour une gravure auto-alignée de la première couche d'isolant de grille 22. Cette gravure met à nu les parties non protégées de la première couche de grille 24.

Une étape suivante consiste à pratiquer une oxydation de la première couche de grille 24. L'oxydation est auto-alignée sur la grille 40 flanquée des premier et deuxième espaceurs. Elle atteint les parties non masquées de la première couche de grille et progresse légèrement sous la couche d'isolant de grille 22. Les parties oxydées de la couche de grille, repérées avec la référence 67 sont électriquement isolantes : elles délimitent ainsi une grille inférieure 70 dans la première couche de grille.

L'oxydation de la première couche de grille a lieu de préférence dans une atmosphère de vapeur d'eau et à une température relativement faible, comprise entre 200 et 700°C. En respectant cette gamme de températures, une diffusion des espèces dopantes des régions de source 52 et de drain 54, vers le canal 50 peut être négligée. La durée du traitement d'oxydation permet d'ajuster le prolongement latéral des régions oxydées 67 et donc les dimensions de la grille inférieure.

La fabrication du transistor peut être poursuivie conformément au procédé décrit en référence aux figures 12 à 15, pour la formation de prolongements latéraux de source et de drain et pour le conditionnement du transistor.

Lors de ces étapes les régions oxydées 67 sont de préférence conservées comme isolant de la grille inférieure. Elles peuvent aussi être sélectivement gravées et remplacées par un autre isolant.

Une autre variante du procédé est décrite en référence aux figures 18 et suivantes.

Les étapes décrites en référence aux figures 18 et suivantes font suite à celles décrites en référence à la figure 5. Toutefois, à la différence de la figure 5, le matériau de la première couche de grille n'est pas choisi avant tout pour ses propriétés conductrices de l'électricité mais pour sa facilité à être éliminé par une gravure sélective. En effet, la première couche de grille 24, visible à la figure 18, est une couche sacrificielle.

La figure 18, montre le dispositif obtenu après la gravure auto-alignée de la deuxième couche d'isolant de grille 22 en utilisant la grille 40, flanquée des premier et deuxième espaceurs 42, 62, comme masque de gravure. La gravure a lieu avec arrêt sur la première couche de grille 24. En dehors des parties protégées par ce masque, la première couche de grille est mise à nu.

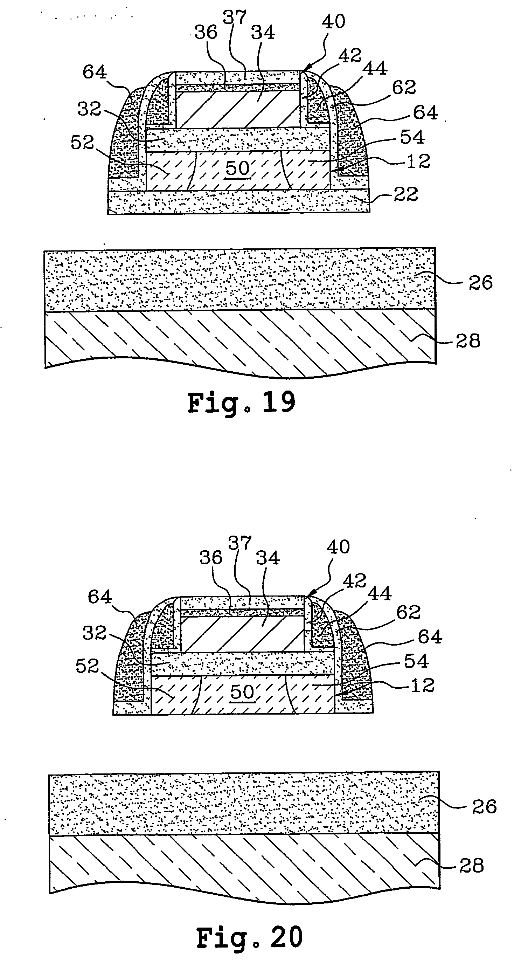

Une étape suivante, illustrée par la figure 19 comprend l'élimination sélective de la première couche de grille 24. L'élimination de la couche de grille peut avoir lieu par une gravure isotrope par voie humide.

Une étape supplémentaire facultative, illustrée par la figure 20 comprend aussi l'élimination sélective de la première couche 22 d'isolant de grille mise à nu sur sa face tournée vers la couche d'isolant de base 26. La première couche d'isolant de grille, en dépit du caractère sélectif des gravures précédentes risque d'avoir été légèrement entamée. Son élimination, puis son remplacement ultérieur, permettent de garantir une meilleure uniformité de l'isolation de grille. Il convient de préciser que, contrairement à l'impression que donnent les figures 19 et 20, la partie du transistor se trouvant initialement au-dessus de la première couche de grille ne flotte pas mais reste maintenue en dehors de la région active, par exemple, par les couches d'isolant de grille. La première couche de grille peut à cet effet être éventuellement mise en forme lors de la formation de l'empilement initial du substrat, à l'instar de la couche active.

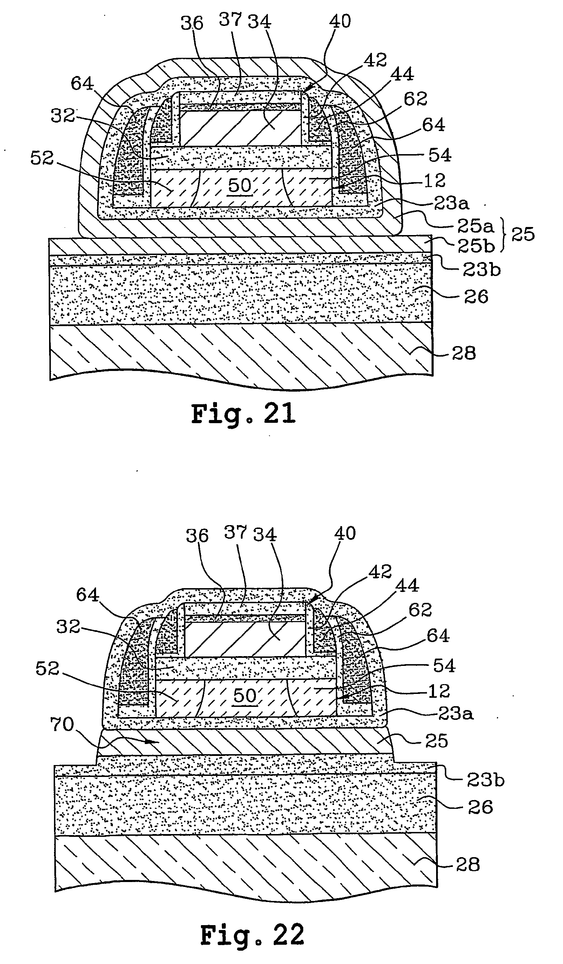

La figure 21 montre la formation d'une nouvelle couche d'isolant de grille 23a par dépôt conforme d'une couche d'oxyde de silicium. La couche 23a est formée sue la face de la couche active 12 tournée vers la couche d'isolant de base 26 ou le bloc de silicium massif 28. Une couche d'isolant équivalente 23b se forme simultanément sur la couche d'isolant de base 26. Selon une autre possibilité, une nouvelle couche d'isolant de grille peut aussi être formée par une oxydation superficielle de la partie exposée de la couche active 12. Dans ce cas une couche d'oxyde supplémentaire ne se forme pas sur la couche d'isolant de base 26.

La formation de la nouvelle couche d'isolant de grille 23a est suivie par le dépôt conforme d'une nouvelle couche de grille 25. Celle-ci se forme également en deux parties 25a et 25b en contact respectivement avec les nouvelles couches d'isolant 23a et 23b, les deux parties se rejoignent pour former la nouvelle couche de grille. La nouvelle couche grille est par exemple en un métal du même type que ceux déjà évoqués pour la fabrication des première et deuxième couches de gille.

On peut observer sur la figure 21 que la nouvelle couche d'isolant de grille 23a et une partie 25a de la nouvelle couche de grille tapissent les parois de la structure de grille, c'est-à-dire de la grille flanquée des espaceurs.

La figure 22, montre le résultat d'une gravure anisotrope sélective visant à éliminer le matériau de la nouvelle grille 25. La gravure a lieu avec arrêt sur la nouvelle couche d'isolant de grille 23b qui tapisse la couche 26 d'isolant de base. Comme le montre la figure 22, la nouvelle couche d'isolant 23b peut éventuellement être légèrement attaquée si la sélectivité est insuffisante. La gravure permet d'éliminer toute la partie de la nouvelle couche de grille qui n'est pas protégée par la structure de grille comprenant la grille 40, les espaceurs et couches de piédestal, de même que la nouvelle couche d'isolant de grille 23a. Il s'agit donc encore d'une gravure auto-alignée sur la grille supérieure 40. La gravure permet de délimiter une grille inférieure 70 centrée sur la grille supérieure et symétrique par rapport à celle ci, notamment dans le plan de coupe de la figure.

La fabrication du transistor peut être complétée comme décrit précédemment en référence aux figures 12 à 15.

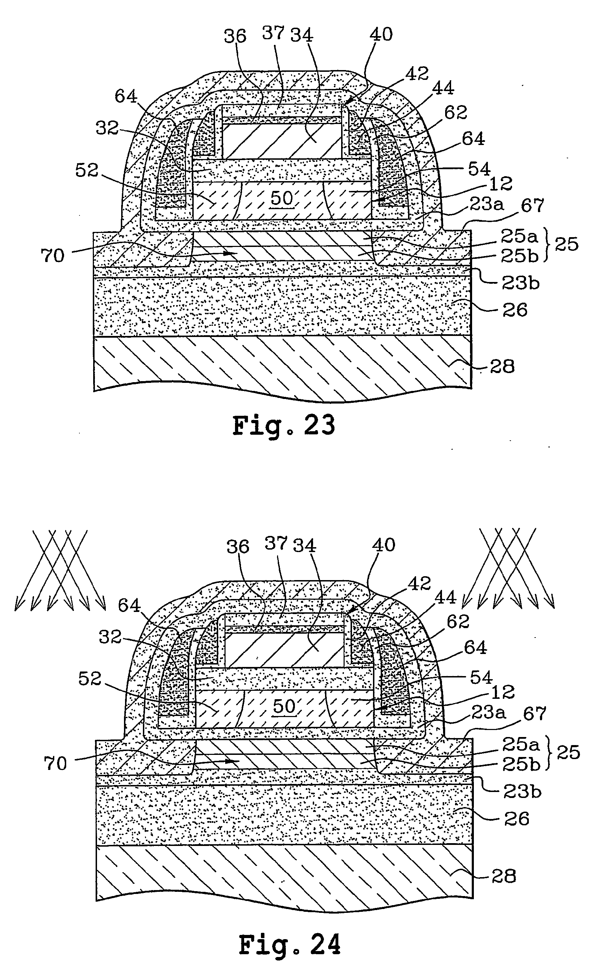

La figure 23 illustre encore une variante du procédé qui fait suite aux étapes décrites en référence à la figure 21. Selon cette variante, la nouvelle grille inférieure n'est pas délimitée par gravure mais par oxydation sélective. En soumettant la structure obtenue au terme des étapes de la figure 21 à une atmosphère oxydante, l'ensemble des parties non protégées de la nouvelle couche de grille 25, et indiquées par la référence 67 sont oxydées et donc rendues électriquement isolantes. L'oxydation est arrêtée par les couches sous-jacentes d'oxyde ou de nitrure de silicium. Comme le montre la figure 23, l'oxydation de la nouvelle couche de grille se poursuit légèrement sous l'ensemble formé par la grille 40, les espaceurs et par la nouvelle couche d'isolant de grille 23a. Cet ensemble forme un masque d'oxydation et permet une définition de la grille inférieure 70 auto-alignée sur la grille supérieure. En soumettant la structure plus ou moins longtemps à une atmosphère oxydante, il est possible de faire progresser plus ou moins la couche d'oxyde 67 et d'ajuster latéralement le prolongement latéral de la grille inférieure 70.

La figure 24 illustre encore une autre variante du procédé qui fait également suite aux étapes décrites en référence à la figure 21.

La structure obtenue au terme de ces étapes est soumise à une implantation de dopage. Le dopage, symbolisé par des flèches, utilise la grille supérieure flanquée des espaceurs 44, 64, et de la nouvelle couche d'isolant de grille 23a, comme masque d'implantation pour former dans la nouvelle couche de grille 25 des régions dopées auto-alignées 66.

Celles-ci délimitent également la grille inférieure 70 qui se trouve de ce fait également auto-alignée sur la grille supérieure.

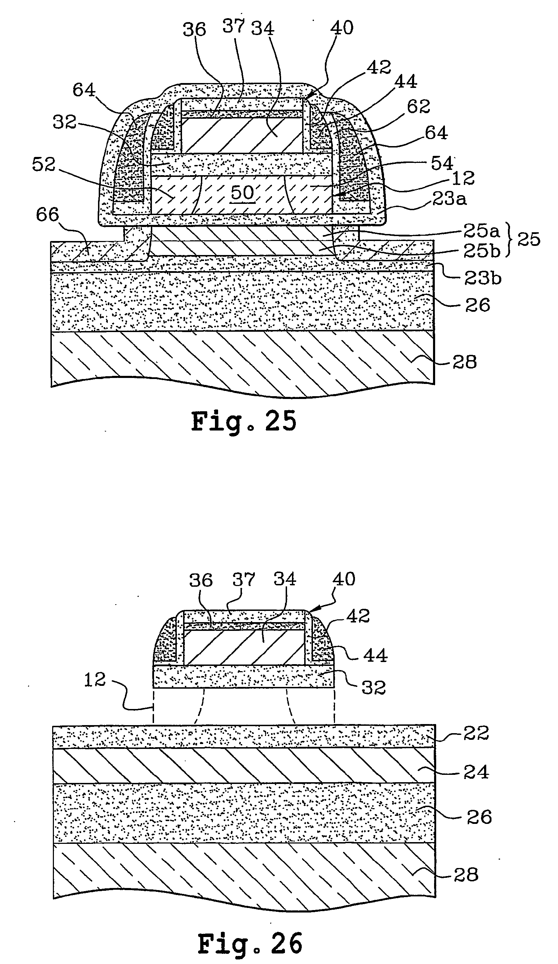

La figure 25 montre une étape subséquente consistant à graver sélectivement les régions dopées. La gravure, auto-alignée sur la grille, les espaceurs et la nouvelle couche d'isolant de grille, peut être partielle ou totale. Elle peut être poursuivie par des étapes d'isolation, de formation de prises de contact et de conditionnement du transistor. La description de ces étapes, déjà donnée précédemment, n'est pas reprise ici.

On décrit à présent différentes possibilités pour la réalisation de prises de contact sur les grilles et pour l'interconnexion des grilles supérieure et inférieure.

La figure 26 est une coupe du dispositif de la figure 3B selon un plan de coupe parallèle à celui de la figure 3B, mais dans une région d'extrémité de la grille 40. Dans cette région, on élimine la couche active 12, représentée en trait discontinu, en la soumettant à une gravure sélective. Lors de cette gravure, une partie du transistor correspondant à une région centrale de la grille est protégée par un masque de gravure. Ce masque a pour fonction d'éviter toute altération de la couche active dans la région centrale qui correspond au plan de coupe de la figure 3B. Les couches qui surmontent la couche active dans la région d'extrémité de la grille sont maintenues notamment par la couche active dans la région ou celle-ci n'est pas éliminée.

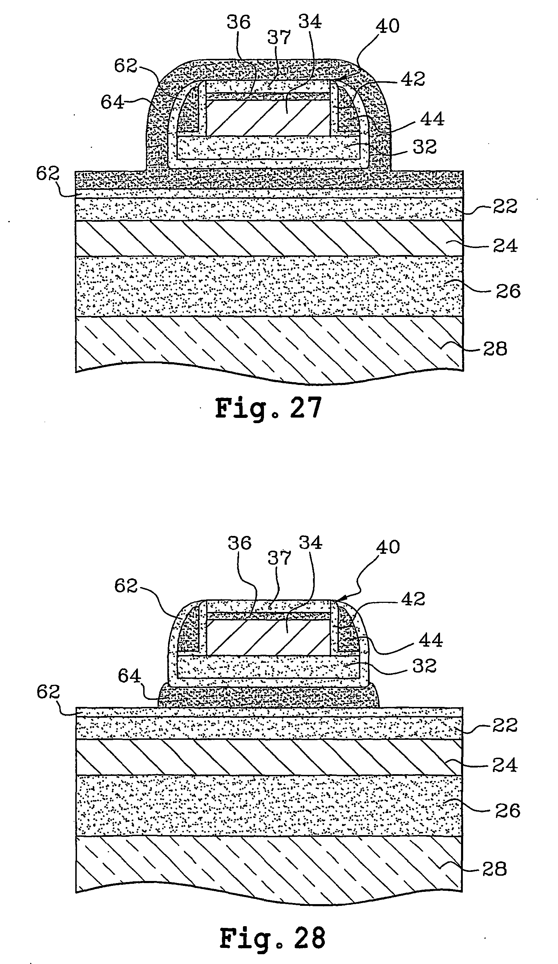

La figure 27, montre la région d'extrémité de la grille lors du dépôt de la deuxième couche de piédestal 62 puis de la couche de nitrure de silicium 64 pour la formation du deuxième espaceur. Le dépôt conforme de ces couches a lieu non seulement sur les flancs des premiers espaceurs 44, mais aussi sur les parties affleurantes des première et deuxième couches d'isolant de grille 22, 32.

La figure 28, montre le résultat d'une gravure anisotrope sélective de la couche de nitrure de silicium, pour en éliminer toutes les parties non protégées par la grille 40, les premiers espaceurs et la deuxième couche de piédestal 62. Il convient de noter que la même gravure est mise à profit pour mettre en forme dans la région centrale de la grille les deuxièmes espaceurs latéraux. On peut se reporter à ce sujet à la figure 4, précédemment décrite.

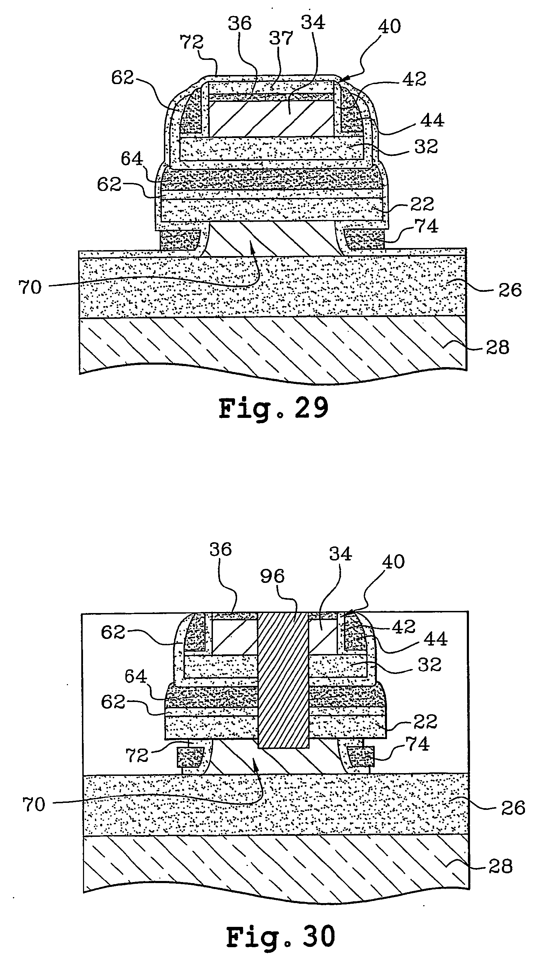

La figure 29, montre, à titre indicatif l'état de la région d'extrémité de la grille, après la délimitation de la grille inférieure 70, la formation de la troisième couche de piédestal 72 et la formation du troisième espaceur enfoui 74. Les étapes opératoires qui conduisent à l'obtention de la structure illustrée par la figure 29 sont les mêmes que celles décrites en référence aux figures 10 et 11. On observe sur la figure 29 qu'il n'y a, entre la grille supérieure 40 et la grille inférieure 70, aucune couche conductrice, mais seulement des couches électriquement isolantes. Il y a notamment les couches d'isolant de grille 22, 32, par exemple en oxyde de silicium, la deuxième couche de piédestal 62, également en oxyde de silicium, et la deuxième couche d'espaceur 64 en nitrure de silicium.

La figure 30 montre la région d'extrémité de la grille après le dépôt de la couche épaisse de matériau isolant 100, et après le planage de cette couche. Un puits est gravé à l'aplomb de la grille supérieure à travers l'ensemble des couches jusqu'à atteindre la grille inférieure. En raison des différents matériaux rencontrés lors de la gravure du puits, celle-ci peut faire appel à différents agents de gravure. Le puits est métallisé, par exemple en le comblant d'un métal tel que Ti, Cu ou W par exemple. Le métal, après mise en forme sur la face libre du dispositif, constitue une prise de contact 96 de grille. Le métal assure également une interconnexion des grilles supérieure et inférieure entre elles. Comme la région active est éliminée dans cette partie du transistor tout risque de court-circuit entre les grilles et le canal ou les régions de source et de drain est évité.

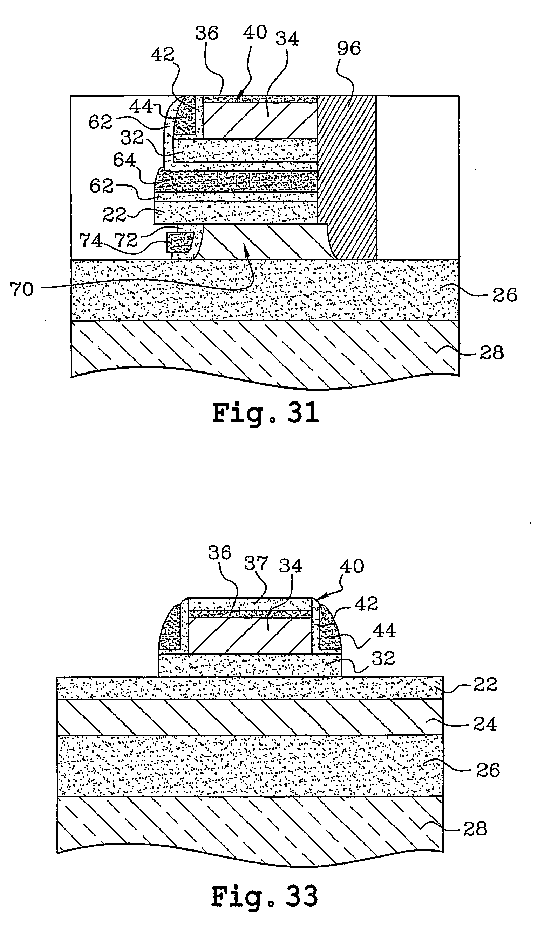

La figure 31, montre la réalisation du puits et de la prise de contact de grille 96, sur le bord de la grille. On peut observer que la prise de contact de grille 96 se prolonge jusque sur la couche d'isolant de base 26.

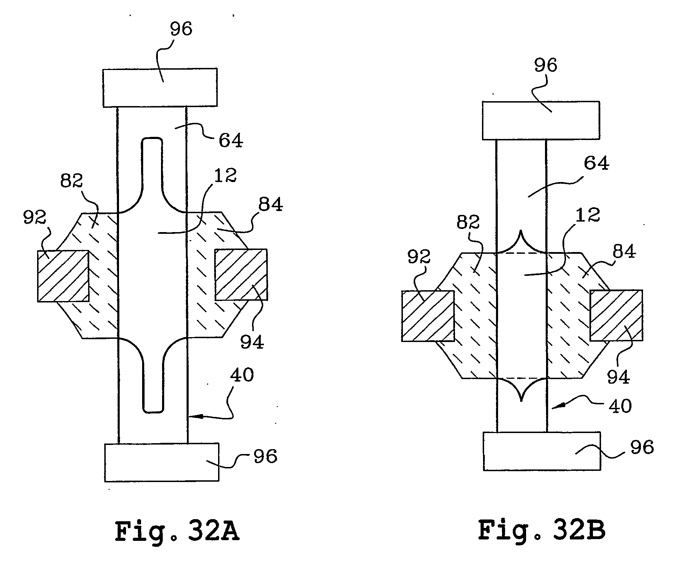

Les figures 32A et 32B sont des coupes schématiques du transistor selon un plan de coupe A-A indiqué sur la figure 15. Ce plan est parallèle au plan principal des couches et passe dans la couche active 12. Sur les figures 32A et 32B, la couche épaisse d'isolant 100 est considérée comme transparente pour des raisons de clarté. On peut observer les prises de contact de source et de drain 92, 94, respectivement en contact avec les régions de prolongement latéral de source et de drain 82, 84. On note également une prise de contact de grille 96 à chaque extrémité de la grille 40. Les deux figures 32A et 32B correspondent respectivement à des situations ou la grille s'étend moins loin qu'un masque de gravure pour la définition de la limite de la région active. Ceci est le cas lorsqu'une gravure isotrope est mise en oeuvre pour la définition de la grille. Une surgravure a lieu sous le masque (non représenté).

Sur la figure 32B, des lignes en trait discontinu marquent la limite d'un masque et d'une grille définie par une gravure anisotrope selon ce masque. Le phénomène de surgravure n'apparaît pas dans ce cas.

Selon une variante du procédé, dans laquelle la région active a été limitée conformément à la figure 2A, on obtient directement, au-delà de la région active, une structure conforme à la figure 33. Cette structure est représentée à un stade du procédé correspondant à la figure 4 précédemment décrite. Comme la couche active est éliminée en dehors de la région active, les couches d'isolant de grille 32 et 22 reposent directement l'une sur l'autre. Dans ce cas également aucune couche conductrice ou semi-conductrice ne sépare les couches 24, 34 dans lesquelles sont définies les grilles supérieure et inférieure. La fabrication d'une prise de contact de grille par gravure d'un puits puis par métallisation de ce dernier peut avoir lieu de la façon décrite précédemment.

### DOCUMENTS CITES

1) FR-A-2 757 312
2) FR-A-2 806 832
3) Scaling Theory for Vth Controlled n+-p+ Double-Gate SOI MOSFETS, Kunihiro Suzuki et al.
4) High-Speed and Low-Power n+-p+ Double-Gate SOI CMOS, IEICE Trans Electron, vol. E-78 C, n°4 April 1995.

## Revendications

1. Procédé de fabrication d'un transistor à doubles grilles auto-alignées comprenant les étapes suivantes :
- la formation d'un empilement de couches comprenant à partir d'un substrat de support (26, 28) : une première couche de grille (24), une couche d'isolant de grille (22), une couche active (12), une deuxième couche d'isolant de grille (32), et une deuxième couche de grille (34),
- la définition d'une grille (40), dite grille supérieure, dans la deuxième couche de grille (34),
- la formation dans la couche active (12) de régions de source et de drain (52, 54) auto-alignées sur la grille supérieure (40), et
- la formation d'une grille (70), dite inférieure soit dans la première couche de grille (24), soit dans une nouvelle couche de grille (25a, 25b, 25) obtenue après remplacement de la première couche de grille, cette grille dite inférieure étant auto-alignée sur la grille supérieure.
- le dopage ionique de la première couche de grille (24) ou de la nouvelle couche de grille (25), auto-aligné sur la grille supérieure (40), en utilisant la grille supérieure comme masque de dopage, pour doper localement la première couche de grille ou la nouvelle couche de grille (25), et la gravure sélective de la partie dopée de la première couche de grille ou de la nouvelle couche de grille (25).

2. Procédé selon la revendication 1, dans lequel on délimite la grille inférieure (70) par gravure sélective auto-alignée sur la grille supérieure.

3. Procédé selon la revendication 1, dans lequel on délimite la grille inférieure (70) par oxydation auto-alignée de la première couche de grille (24).

4. Procédé selon la revendication 1, dans lequel on délimite la nouvelle couche de grille (25) par gravure sélective auto-alignée sur la grille supérieure.

5. Procédé selon la revendication 1, dans lequel on délimite la nouvelle couche de grille (25) par oxydation auto-alignée sur la première couche de grille.

6. Procédé selon la revendication 1, dans lequel on forme des première et deuxième grilles s'étendant dans une région s'étendant au delà de la région active, et on pratique dans la région s'étendant au-delà de la région active un puits métallisé (96) traversant l'empilement des couches pour relier électriquement la grille supérieure (40) à la grille inférieure (70).

7. Procédé selon la revendication 1, comprenant en outre, la gravure auto-alignée de la couche active (12), en utilisant la grille supérieure (40) comme masque de gravure.

8. Procédé selon la revendication 7, dans lequel on forme sur la grille supérieure des premiers espaceurs (44) avant la gravure auto-alignée de la couche active (12).

9. Procédé selon la revendication 7, dans lequel on délimite la grille inférieure (70) postérieurement à la gravure de la couche active, et on utilise la couche active et la grille supérieure comme masques de gravure.

10. Procédé selon la revendication 9, dans lequel on forme sur la grille supérieure et sur la couche active des deuxièmes espaceurs (64), avant de délimiter la grille inférieure.

11. Procédé selon la revendication 1, dans lequel on forme sur les régions de source et de drain (52, 54) des prolongements latéraux de source et de drain (82, 84), les prolongements latéraux étant formés par épitaxie.

12. Procédé selon la revendication 11, dans lequel, après la formation des prolongements latéraux, on isole le transistor, puis on forme des prises de contact (92, 94) sur les prolongements latéraux de source et de drain.

## Claims

1. A process for manufacturing a transistor with self-aligned double gates comprising the following stages:
- formation of a stack of layers comprising from a support substrate (26, 28): a first gate layer (24), an insulating gate layer (22), an active layer (12), a second insulating gate layer (32), and a second gate layer (34),
- definition of a gate (40), said upper gate, in the second gate layer (34),
- formation in the active layer (12) of source and drain regions (52, 54) self-aligned on the upper gate (40), and
- formation of a gate (70), said lower gate (70), either in the first gate layer (24) or in a new gate layer (25a, 25b, 25) obtained after replacement of the first gate layer, said lower gate being self-aligned on the upper gate,
- ionic doping of the first gate layer (24) or of the new gate layer (25), self-aligned on the upper gate (40), by using the upper gate as doping mask, to locally dope the first gate layer or the new gate layer (25), and selective etching of the first gate layer or of the new gate layer (25).

2. The process as claimed in Claim 1, wherein the lower gate (70) is delimited by selective etching self-aligned on the upper gate.

3. The process as claimed in Claim 1, wherein the lower gate (70) is delimited by oxidation self-aligned of the first gate layer (24).

4. The process as claimed in Claim 1, wherein the new gate layer (25) is delimited by selective etching self-aligned on the upper gate.

5. The process as claimed in Claim 1, wherein the new gate layer (25) is delimited by self-aligned oxidation on the first gate layer.

6. The process as claimed in Claim 1, wherein first and second gates extending into a region extending beyond the active region are formed, and a metallised well (96) traversing stack of the layers electrically link the upper gate (40) to the lower gate (70) is arranged in the region extending beyond the active region.

7. The process as claimed in Claim 1, further comprising self-aligned etching of the active layer (12), by using the upper gate (40) as etching mask.

8. The process as claimed in Claim 1, wherein first spacers (44) are formed on the upper gate before self-aligned etching of the active layer (12).

9. The process as claimed in Claim 7, wherein the lower gate (70) is delimited prior to etching of the active layer, and the active layer and the upper gate are utilised as etching masks.

10. The process as claimed in Claim .... , wherein second spacers (64) are formed on the upper gate and on the active layer, before delimiting the lower gate.

11. The process as claimed in Claim 1, wherein the lateral extensions of source and drain (82, 84) are formed on the source and drain regions (52, 54), the lateral extensions being formed by epitaxy.

12. The process as claimed in Claim 11, wherein, after formation of the lateral extensions, the transistor is insulated, then contacts (92, 94) are formed on the lateral extensions of source and drain.

## Patentansprüche

1. Verfahren zur Herstellung eines Transistors mit zwei selbstjustierenden Gate-Elektroden, umfassend die folgenden Schritte:
- das Formen eines Schichtstapels, umfassend, von einem Substrat (26, 28) ausgehend: eine erste Gate-Schicht (24), eine Gate-Isolierschicht (22), eine aktive Schicht (12), eine zweite Gate-Isolierschicht (32) und eine zweite Gate-Schicht (34),
- das Definieren eines Gates (40), oberes Gate genannt, in der zweiten Gate-Schicht (34),
- das Formen, in der aktive Schicht (12), von Source- und Drain-Regionen (52, 54), die zum oberen Gate (40) selbstjustierend sind, und
- das Formen eines Gates (70), unteres Gate genannt, entweder in der ersten Gate-Schicht (24) oder in einer neuen Gate-Schicht (25a, 25b, 25), die nach Ersatz der ersten Gate-Schicht erhalten wird, wobei dieses untere Gate zum oberen Gate selbstjustierend ist.
- das zum oberen Gate (40) selbstjustierende ionische Dotieren der ersten Gate-Schicht (24) oder der neuen Gate-Schicht (25), indem das obere Gate als Dotierungsmaske verwendet wird, um die erste Gate-Schicht oder die neue Gate-Schicht (25) lokal zu dotieren, und das selektive Ätzen des dotierten Teils der ersten Gate-Schicht.

2. Verfahren nach Anspruch 1, wobei das untere Gate (70) zum oberen Gate durch selektives, selbstjustierendes Ätzen abgegrenzt wird.

3. Verfahren nach Anspruch 1, wobei das untere Gate (70) durch selbstjustierende Oxidation der ersten Gate-Schicht (24) abgegrenzt wird.

4. Verfahren nach Anspruch 1, wobei die neue Gate-Schicht (25) durch selektives, zum oberen Gate selbstjustzerendes Ätzen abgegrenzt wird.

5. Verfahren nach Anspruch 1, wobei die neue Gate-Schicht (25) durch zur ersten Gate-Schicht selbstjustierende Oxidation abgegrenzt wird.

6. Verfahren nach Anspruch 1, wobei erste und zweite Gates geformt werden, die sich in einer Region verstrecken, die jenseits der aktiven Region liegt, und in der Region, die jenseits der aktiven Region liegt, ein metallischer Well (96) hergestellt wird, der den Schichtstapel durchquert, um das obere Gate (40) mit dem unteren Gate (70) zu verbinden.

7. Verfahren nach Anspruch 1, umfassend außerdem das selbstjustierende Ätzen der aktiven Schicht (12), indem das obere Gate (40) als Ätzmaske versendet wird.

8. Verfahren nach Anspruch 7, wobei vor dem selbstjustierennen Ätzen der aktive Schicht (12) erste Abstandshalter (44) auf dem oberen Gate geformt werden.

9. Verfahren nach Anspruch 7, wobei das untere Gate (70) nach dem Ätzen der aktiven Schicht abgegrenzt wird und die aktive Schicht und das obere Gate als Ätzmasken verwendet werden.

10. Verfahren nach Anspruch 9, wobei auf dem oberen Gate und auf der aktiven Schicht zweite Abstandshalter (64) geformt werden, bevor das untere Gate abgegrenzt wird.

11. Verfahren nach Anspruch 1, wobei auf den Source- und Drain-Regionen (52, 54) seitliche Source- und Drain-Verlängerungen (82, 84) geformt werden, wobei diese seitlichen Verlängerungen durch Epitaxie geformt werden.

12. Verfahren nach Anspruch 11, wobei nach der Formung der seitlichen Verlängerungen der Transistor isoliert wird und dann die Kontaktanschlüsse (92, 94) auf den seitlichen Source- und Drain-Verlängerungen geformt werden.
